# FASCICULE DE BREVET EUROPEEN

(11) **EP 2 218 102 B1**
(45) Date de publication et mention de la délivrance du brevet: **10.02.2016**
(21) Numéro de dépôt: 08870576.9
(22) Date de dépôt: 24.10.2008
(51) Int. Cl.: B82Y 10/00, B82Y 40/00, H01L 23/48, H01L 23/49, H01L 21/60, H01L 21/02, H01R 4/26, H01L 25/065, H01L 29/41

(54) **PROCEDE DE FABRICATION D'UN ELEMENT D'INTERCONNEXION MECANIQUE CONDUCTEUR D'ELECTRICITE**
VERFAHREN ZUR HERSTELLUNG EINES ELEKTRISCH LEITFÄHIGEN MECHANISCHEN VERBINDUNGSELEMENTS
METHOD FOR MAKING AN ELECTRICALLY CONDUCTING MECHANICAL INTERCONNECTION MEMBER

(30) Priorité: 26.10.2007 FR 0707566
(43) Date de publication de la demande: 18.08.2010
(73) Titulaire: Centre National de la Recherche Scientifique, 75016 Paris (FR); Université Paul Sabatier, 31062 Toulouse Cedex 9 (FR)
(72) Inventeur: SIMON, Patrice, F-31400 Toulouse (FR); TABERNA, Pierre-Louis, F-31750 Escalquens (FR); LEBEY, Thierry, F-31120 Lacroix Falgarde (FR); CAMBRONNE, Jean Pascal, F-31320 CASTANET (FR); BLEY, Vincent, F-31750 Escalquens (FR); LUAN, Quoc Hung, F-31100 Toulouse (FR); TARASCON, Jean Marie, F-91540 Mennecy (FR)
(74) Mandataire: Reboussin, Yohann Mickaël Noël
(86) Numéro de dépôt international: PCT/FR2008/001497
(87) Numéro de publication internationale: WO 2009/090349

(56) Documents cités:
- EP-A- 1 100 106
- EP-A- 1 100 297
- EP-A- 1 320 111
- EP-A- 1 583 146
- WO-A-2006/098026
- WO-A-2006/123049
- US-A1- 2006 043 598
- US-B1- 6 231 744

## Description

L'invention porte sur un procédé de fabrication d'un élément d'interconnexion mécanique conducteur d'électricité, ainsi que sur un procédé pour la réalisation d'une interconnexion mécanique.

L'invention s'applique, en particulier, au domaine de l'électronique.

En électronique, il est constamment nécessaire de réaliser des interconnexions mécaniques conductrices d'électricité. On pense en particulier à la connexion des broches d'une puce microélectronique à une piste ou plage de métallisation d'un circuit imprimé pour la réalisation d'une carte électronique.

Typiquement, ces connexions électriques et mécaniques sont réalisées par brasage ou soudure, voire par thermo-compression. Ces techniques conventionnelles présentent de nombreux inconvénients. Premièrement, elles nécessitent des températures élevées, qui peuvent endommager des composants électroniques fragiles. Deuxièmement, elles ne peuvent pas être défaites facilement. Or, il est souvent important de pouvoir démonter et remonter une puce d'une carte électronique, pour la tester, la réparer et/ou la remplacer.

Les problèmes d'interconnexion sont particulièrement aigus dans le cas des composants électroniques à intégration tridimensionnelle, obtenus en empilant et en interconnectant des dispositifs planaires tels que des puces ou des circuits imprimés miniaturisés. Une fois l'assemblage réalisé, il est généralement impossible de le défaire sans détruire les éléments planaires qui le composent.

Le document EP1583146 divulgue un élément d'interconnexion nanostructuré, constitué par une surface métallique de laquelle font saillie des fils conducteurs de diamètre sub-micrométrique (« nanofils »). Une interconnexion à la fois mécanique et électrique est réalisée en pressant lesdites surfaces l'une contre l'autre. De cette manière se réalise un enchevêtrement des nanofils, qui crée une liaison entre les surfaces. L'interconnexion ainsi obtenue peut être défaite simplement en appliquant une force de traction suffisamment intense, puis être reconstituée par une nouvelle étape de compression.

Le document EP1583146 ne décrit de manière détaillée aucun procédé permettant la fabrication d'un tel élément d'interconnexion, se bornant à citer le document antérieur US6185961.

Ce dernier document décrit un procédé pour fabriquer une pluralité de nanofils métalliques faisant saillie d'une surface, comportant : la fabrication d'une matrice poreuse en verre, le dépôt par vaporisation ou pulvérisation d'une couche de métal noble sur une face de ladite matrice, la fabrication des nanofils par dépôt électrochimique dans les pores de la matrice et la dissolution de cette dernière pour libérer l'élément métallique nanostructuré ainsi obtenu. Ce procédé est très complexe et couteux, surtout en ce qui concerne les étapes de fabrication et de métallisation de la matrice. De plus, la nécessité d'une étape de dépôt par pulvérisation ou vaporisation d'un film mince conducteur électronique limite le choix des matériaux utilisables. Par exemple, il n'est pas possible de réaliser une nanostructure entièrement en cuivre.

D'autres procédés de fabrication de structures constitués par une pluralité de nanofils conducteurs faisant saillie d'une surface sont connus de l'art antérieur. Cependant, ces structures ne s'avèrent pas adaptées à la réalisation d'interconnexions mécaniques par enchevêtrement des nanofils.

Par exemple, l'article de S. Fiedler et al. « Evaluation of metallic nano-lawn structures for application in microelectronic packaging » décrit un procédé de fabrication d'une telle nanostructure par un procédé électrolytique globalement semblable à celui du document US 6,185,961, sauf en ce que la matrice en verre est remplacée par une membrane polymère dans laquelle des pores sont creusés par bombardement par des particules. L'inconvénient de ce procédé est que les pores ainsi obtenus (et donc les nanofils qui sont déposés à l'intérieur de ces derniers) ne sont pas rectilignes et leur disposition est aléatoire. L'expérience montre qu'une interconnexion satisfaisante ne peut pas être réalisée de cette manière. Tout au plus, le procédé permet de créer des nanostructurations sur des plages de métallisation de puces microélectroniques ou circuits imprimés, ce qui facilite leur connexion par brasage.

Le document WO2006/123049 divulgue encore un autre procédé de fabrication d'une nanostructure constituée par une pluralité de nanofils métalliques faisant saillie d'une surface d'un substrat. Ce procédé prévoit, lui aussi, la formation des nanofils par dépôt électrochimique dans les pores d'une matrice sacrificielle. L'originalité du procédé réside dans l'utilisation d'une matrice constituée par une membrane en matériau céramique poreux, et plus précisément en alumine. Le procédé du document WO2006/123049 est avantageux car les pores des membranes en alumine sont sensiblement rectilignes et disposés selon un réseau régulier. En outre, il n'est pas nécessaire de procéder à une métallisation préalable par vaporisation ou pulvérisation de cette membrane.

Les présents inventeurs, cependant, se sont rendu compte du fait que les structures ainsi obtenues ne permettent pas de réaliser des interconnexions mécaniques par interpénétration et enchevêtrement des nanofils, et cela même en réalisant une pluralité d'essais avec différentes membranes en alumine poreuse disponibles dans le commerce. En effet, le document WO2006/123049 ne fait pas état d'une telle application.

Un but de l'invention est de remédier aux inconvénients précités de l'art antérieur afin de fournir un procédé simple et économique pour la réalisation d'éléments d'interconnexions mécaniques du type basé sur l'interpénétration et enchevêtrement de nanofils conducteurs.

Un tel but peut être atteint par un procédé de fabrication d'un élément d'interconnexion mécanique conducteur d'électricité, ledit procédé comportant les étapes consistant à :
i. disposer, dans une cellule électrolytique, une solution électrolytique contenant un composé précurseur d'un matériau métallique ;
ii. immerger dans ladite solution un substrat conducteur dont au moins une face est revêtue d'une membrane poreuse, présentant un réseau sensiblement régulier de pores rectilignes et traversants ;
iii. disposer une électrode en regard de ladite ou de chaque membrane poreuse, mais espacée de cette dernière ;
iv. relier ledit substrat à une borne négative d'un générateur d'électricité, de manière à qu'il constitue une cathode, et ladite électrode à une borne positive dudit générateur, de manière à qu'elle constitue une anode, pour effectuer un dépôt électrolytique dudit matériau métallique sur la surface du substrat à travers les pores de ladite membrane ;
v. dissoudre ladite membrane poreuse, de manière à libérer une structure comportant une pluralité de fils de diamètre sub-micrométrique constitués dudit matériau métallique et faisant saillie de la surface dudit substrat ;
caractérisé en ce que ledit procédé comporte également une étape additionnelle vi. de dissolution contrôlée partielle desdits fils pour en réduire le diamètre de manière à augmenter la force d'adhésion qui s'exerce entre deux desdites structures, par interpénétration et enchevêtrement desdits fils, lorsqu'elles sont pressées l'une contre l'autre.

Selon des modes de réalisation particuliers de l'invention :
- Ladite membrane poreuse peut être réalisée en matériau céramique, et plus particulièrement en alumine.
- Ladite membrane poreuse peut présenter une densité de pores comprise entre 10⁷ cm⁻² et 10¹⁰ cm⁻², et de préférence de l'ordre de 10⁹ cm⁻².
- Après ladite étape vi de dissolution contrôlée partielle, lesdits fils peuvent présenter un diamètre compris entre 5 et 300 nm, et de préférence entre 10 et 200 nm, et/ou une longueur comprise entre 200 nm et 200 µm et de préférence entre 500 nm et 100 µm.
- Egalement après ladite étape vi de dissolution contrôlée partielle, ledit élément d'interconnexion peut présenter une porosité comprise entre 0,5 et 0,9.
- Ledit matériau métallique peut être choisi parmi : Cu, Sn, Co, Fe, Pb, Ni, Cr, Au, Pd, Pt, Ag, Bi, Sb, Si, Al ou Li, ou un alliage de ces métaux. De préférence, ledit matériau métallique peut être le même matériau qui constitue ledit substrat conducteur, de manière à obtenir une structure d'interconnexion constituée d'un seul matériau.
- Ladite étape de dissolution partielle contrôlée peut être un procédé de dissolution électrolytique.
- En variante, ladite étape de dissolution partielle contrôlée peut être réalisée par immersion de ladite structure dans une solution permettant l'oxydation dudit matériau métallique, ainsi que la solubilisation des produits d'oxydation de ce dernier.
- Ledit substrat conducteur peut être constitué par une plage de métallisation d'une puce microélectronique, ou par une piste ou plage de métallisation d'un circuit imprimé. En particulier, ledit élément d'interconnexion mécanique peut être destiné à réaliser également une connexion électrique.

Un autre objet de l'invention est un procédé pour la réalisation d'une interconnexion mécanique, comportant les étapes consistant à :
- fabriquer deux éléments d'interconnexion par un procédé tel que décrit ci-dessus ; et
- disposer face à face lesdits éléments d'interconnexion et les presser l'un contre l'autre de manière à réaliser une interpénétration et un enchevêtrement des fils nanométriques faisant saille des surfaces desdits éléments. Avantageusement lesdits éléments d'interconnexion peuvent être pressés l'un contre l'autre par une pression comprise entre 20 MPa et 100 MPa.

Encore un autre objet de l'invention est un procédé de fabrication d'un dispositif microélectronique tridimensionnel constitué par un empilement d'une pluralité de puces microélectroniques reliées entre elles mécaniquement et électriquement, caractérisé en ce qu'au moins l'interconnexion mécanique entre lesdites puces est réalisée conformément à au procédé décrit ci-dessus.

D'une manière particulièrement avantageuse, au moins certains des éléments d'interconnexion mécanique reliant entre elles lesdites puces microélectroniques peuvent former des canaux étanches pour la circulation d'un fluide caloporteur.

Encore un autre objet de l'invention est un dispositif électronique tridimensionnel comportant un empilement de puces microélectroniques reliées entre elles mécaniquement et électriquement, dans lequel des puces adjacentes dudit empilement présentent, sur leurs surfaces opposées, des éléments d'interconnexion se faisant face, comportant des plages de métallisation et une pluralité de fils de diamètre sub-micromètrique faisant saillie de ces dernières, et dans lequel les puces sont reliées entre elles par interpénétration et enchevêtrement des fils desdits éléments d'interconnexion caractérisé en ce que au moins certains desdits éléments d'interconnexion se présentent sous la forme de bandes parallèles, non nécessairement rectilignes, qui traversent la puce d'un côté à un autre, de manière à constituer des parois étanches délimitant au moins un tube pour la circulation d'un fluide caloporteur.

Selon des modes de réalisation particuliers du dispositif de l'invention :
- La densité desdits fils de diamètre sub-micromètrique peut être comprise entre 10⁷ cm⁻² et 10¹⁰ cm⁻², et dé préférence de l'ordre de 10⁹ cm⁻².
- Lesdits fils peuvent présenter un diamètre compris entre 5 et 300 nm, et de préférence entre 10 et 200 nm, et/ou une longueur comprise entre 200 nm et 200 µm, et de préférence entre 500 nm et 100 µm.
- Ledit élément d'interconnexion peut présenter une porosité comprise entre 0,5 et 0,9.
- Lesdits fils de diamètre sub-micromètriques peuvent être réalisés en un matériau métallique choisi parmi : Cu, Sn, Co, Fe, Pb, Ni, Cr, Au, Pd, Pt, Ag, Bi, Sb, Si, Al ou Li, ou un alliage de ces métaux.

D'autres caractéristiques, détails et avantages de l'invention ressortiront à la lecture de la description faite en référence aux dessins annexés donnés à titre d'exemple et qui représentent, respectivement :
- La figure 1, les étapes i. à v. d'un procédé selon l'invention ;
- La figure 2, l'étape vi. de ce même procédé ;
- La figure 3A, une vue du haut, au microscope électronique, d'un élément d'interconnexion réalisé conformément au procédé de l'invention
- La figure 3B, une vue latérale, au microscope électronique à balayage, d'une interconnexion électrique et mécanique réalisée conformément au procédé de l'invention ; et
- Les figures 4A et 4B, un exemple particulier d'une structure microélectronique utilisant des interconnexions mécaniques pouvant être obtenues par le procédé de l'invention.

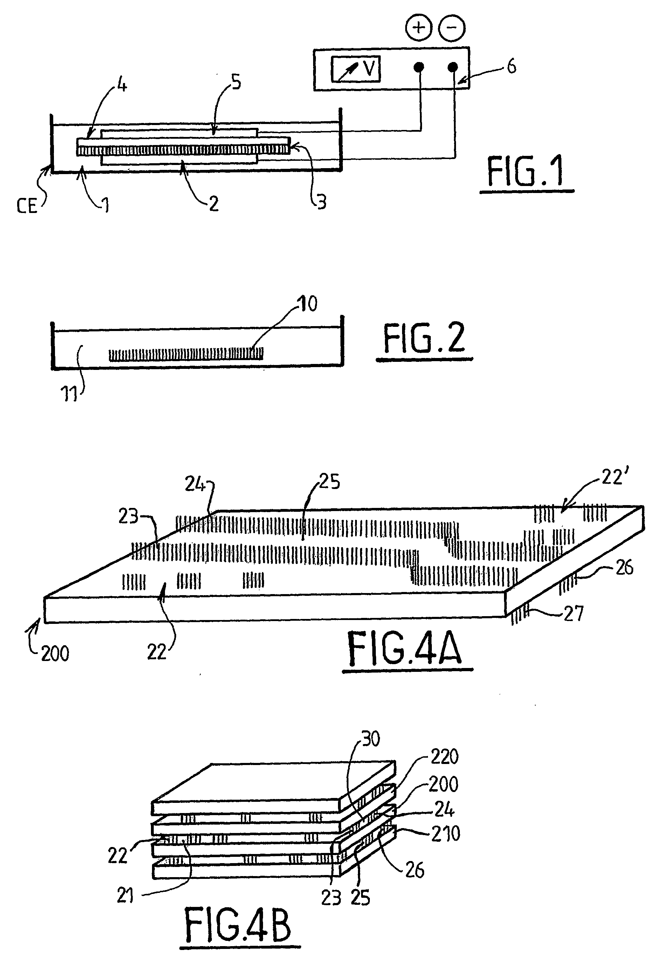

Le procédé de fabrication d'un élément d'interconnexion mécanique conducteur d'électricité selon l'invention se compose de deux phases. La première, qui est représentée de manière schématique sur la figure 1, est décrite en détail par le document WO2006/123049.

Elle comporte les étapes consistant à :
Etape i : disposer, dans une cellule électrolytique CE, une solution électrolytique 1 d'un composé précurseur d'un matériau métallique. Typiquement, il pourra s'agir d'une solution aqueuse ou organique d'un ou plusieurs sels métalliques. Le ou les métaux peuvent être choisis en particulier parmi les suivants : Cu, Sn, Co, Fe, Pb, Ni, Cr, Au, Pd, Pt, Ag, Bi, Sb, Al, Si, ou Li. Si on utilise des sels de métaux différents, on veillera à ce que lesdits métaux puissent se combiner en un alliage. A titre d'exemple spécifique, la solution électrolytique peut être une solution aqueuse de CuSO₄ (100 g/l), (NaH₄)₂SO₄(20 g/l) et diéthylènetriamine (80 g/l).
Etape ii: immerger dans ladite solution 1 un substrat conducteur 2 dont au moins une face est revêtue d'une membrane poreuse 3, présentant un réseau sensiblement régulier de pores rectilignes et traversants. Le substrat conducteur 2 peut être constitué par une plage de métallisation d'une puce microélectronique « nue », ou par une piste d'un circuit intégré. Quant à la membrane, elle est de préférence en alumine, elle a une épaisseur de quelques centaines de nanomètres à quelques dizaines de µm et présente 10⁷ - 10¹⁰ pores (10⁹ étant une valeur préférée) substantiellement cylindriques, d'un diamètre approximativement uniforme de 50 - 500 nm et repartis selon un réseau hexagonal régulier. Une membrane de ce type est commercialisée sous la dénomination « Anodisc » par la société Whatman.

En variante, des membranes constituées par d'autres matériaux peuvent être utilisées ; ce qui importe le plus, est qu'elles présentent un réseau sensiblement régulier de pores rectilignes et traversants. En l'état actuel de la technique, les meilleurs résultats sont obtenus avec des membranes en alumine. D'autres matériaux céramiques tels que l'oxyde de titane TiO₂ constituent des alternatives acceptables, bien que moins satisfaisantes.
Etape iii : disposer une électrode 5 en regard de ladite ou de chaque membrane poreuse, mais espacée de cette dernière. Cette électrode peut, par exemple, être constituée par une feuille de cuivre, espacée de la membrane 3 par une feuille cellulosique perméable 4.
Etape iv : relier ledit substrat 2 à une borne négative d'un générateur d'électricité 6, de manière à qu'il constitue une cathode, et ladite électrode 5 à une borne positive dudit générateur 6, de manière à qu'elle constitue une anode, pour effectuer un dépôt électrolytique dudit matériau métallique sur la surface du substrat à travers les pores de ladite membrane. Le dépôt peut être effectué en continu ou de manière impulsionnelle. Par exemple, un protocole de mise en oeuvre du procédé peut prévoir la répétition, pendant 30 minutes, d'une séquence comportant l'application d'un courant de 1 mA/cm² pendant 250 ms et d'un courant de 20 mA/cm² pendant 50 ms.
Etape v : dissoudre ladite membrane poreuse 3, par exemple par immersion dans une solution 1M de soude à 80°C pendant 30s, suivie par un rinçage pendant 10 s dans une solution aqueuse de H₂SO₄ (1M) et CuSO₄ (1M).

La dissolution de la membrane 3 libère une structure 10 en forme de « brosse », constituée par une pluralité de fils métalliques de diamètre sub-micrométrique (« nanofils ») 2a faisant saillie de la surface dudit substrat 2. Les fils 2a constituent l'empreinte des pores de la membrane : les caractéristiques de cette dernière déterminent par conséquent le diamètre, la densité et la longueur des nanofils.

Les présents inventeurs ont réalisé plusieurs essais en utilisant différentes membranes d'alumine poreuse disponibles dans le commerce. Dans aucun cas ils n'ont réussi à réaliser une interconnexion électrique et mécanique suffisamment solide par compression de deux structures ainsi obtenues et disposées face à face.

De manière inattendue, les inventeurs se sont rendu compte qu'une interconnexion présentant des bonnes propriétés électriques et mécanique peut être obtenue si, préalablement, on amincit les nanofils par une étape ultérieure (étape vi) de dissolution contrôlée partielle. Il semblerait que la plus grande porosité des « brosses » après cette étape de dissolution partielle permet une meilleure interpénétration des nanofils et donc un contacte plus intime entre les deux structures pressées l'une contre l'autre.

Cette dissolution contrôlée peut se faire par plusieurs méthodes, à savoir avec ou sans courant ou polarisation imposée. La méthode sans courant ou polarisation imposée, dite « electroless » en anglais, représentée sur la figure 2, est réalisée par simple immersion de la structure 10 dans une solution 11 permettant la dissolution contrôlée du métal constituant les nanofils. Cette solution doit permettre l'oxydation du métal ainsi que la solubilisation des produits d'oxydation de ce dernier. Par exemple, il peut s'agir d'un mélange d'un acide avec un composé plus oxydant que le métal à dissoudre. Par exemple, dans le cas de nanofils en cuivre, on peut utiliser un mélange de H₂SO₄ avec une concentration comprise entre 0,01 et 1M (de préférence 0,1 M) et de H₂O₂ avec une concentration comprise entre 0,3 et 0,003M (de préférence 0,03 M).

Une solution basique peut être utilisée en remplacement de la solution acide de l'exemple.

D'autres méthodes nécessitant l'application d'un courant ou d'un potentiel anodique permettent également une dissolution contrôlée partielle des nanofils. Parmi ces méthodes, on peut citer les polarisations galvanostatiques, potentiostatiques, ou encore les polarisations impulsionnelles sous potentiel ou sous courant continu ou alternatif. Dans ces cas, la dissolution peut se faire dans la même solution 1 utilisée pour l'étape (iv) de dépôt.

L'élément d'interconnexion obtenu à l'issue de l'étape vi de dissolution contrôlée partielle présente typiquement entre 10⁷ et 10¹⁰ fils·cm⁻² (de préférence, de l'ordre de 10⁹), lesdits fils présentant un diamètre généralement compris entre 5 et 300 nm, et de préférence entre 10 et 200 nm, et une longueur généralement comprise entre 200 nm et 200 µm, et de préférence entre 500 nm et 100 µm. Généralement, la longueur des fils est inférieure ou égale à l'épaisseur de la membrane.

La porosité de l'élément d'interconnexion (définie comme étant le rapport du volume des espaces vides par rapport au volume total de la « brosse ») est typiquement comprise entre 0,5 et 0,9, et typiquement de l'ordre de 0,75, bien qu'une mesure précise de ce paramètre soit difficile.

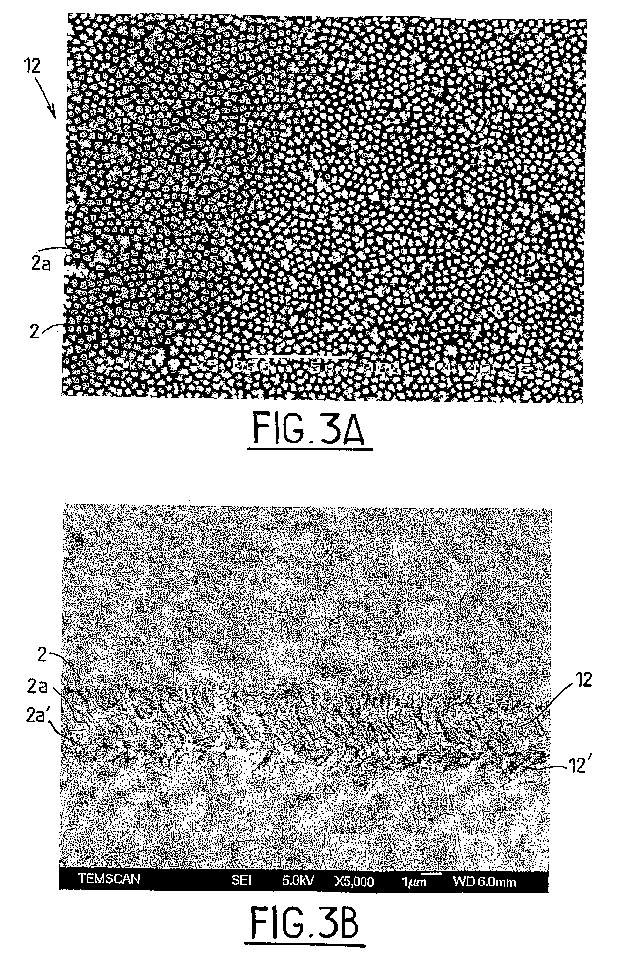

La figure 3A est une vue au microscope électronique d'un élément d'interconnexion 12 réalisée par un procédé selon l'invention, comportant un substrat en cuivre 2 de la surface duquel font saille des « nanofils » 2a, également en cuivre, ayant une longueur de l'ordre de 3µm et un diamètre de l'ordre de 200 nm. La densité des nanofils F est de l'ordre de 10⁹ cm⁻².

La figure 3B est une vue au microscope électronique d'une interconnexion réalisée en pressant l'un contre l'autre deux éléments d'interconnexions 12, 12' identiques, du type représenté sur la figure 3A. On peut voir l'interpénétration et l'enchevêtrement des nanofils 2a, 2a', responsable de la liaison mécanique. L'interconnexion a été réalisée par application d'une pression de 50 MPa, et la force de liaison qui s'exerce entre les éléments 12, 12' est de l'ordre de 5 N/cm². Cette interconnexion peut être défaite par simple traction, sans endommagement apparent des nanofils. Trois cycles de formation et défection de l'interconnexion peuvent être réalisés en succession sans que la force de liaison ne décroisse de manière appréciable.

Plus généralement, les pressions utilisées pour la formation des interconnexions peuvent être comprises entre 20 et 100 MPa, et les forces de liaison entre 3 et 10 N/cm².

Les éléments d'interconnexion de l'invention peuvent être utilisés pour réaliser des assemblages électroniques à puce retournée (« flip chip »). Dans ce cas, les plages de métallisation de la puce et du circuit intégré sont utilisées comme substrats pour le dépôt électrochimique des nanofils. Par rapport aux techniques d'assemblage électronique conventionnelles, l'utilisation d'une interconnexion de ce type permet d'éviter tout risque de surchauffe de la puce lors d'une étape de brasage. De plus le démontage de la puce, qui peut s'avérer nécessaire pour la tester, réparer ou remplacer, se trouve grandement facilité.

De préférence, les éléments d'interconnexion assurent aussi bien une connexion électrique que mécanique, et parfois même thermique. Mais ces fonctions peuvent également être dissociées.

Une application particulièrement intéressante de l'invention est l'intégration tridimensionnelle, qui consiste à empiler des dispositifs planaires tels que des puces ou des circuits imprimés miniaturisés. Une technique d'intégration tridimensionnelle connue de l'art antérieur est décrite dans le document EP0490739. Les éléments d'interconnexion de l'invention peuvent simplifier la réalisation de tels dispositifs tridimensionnels, en assurant aussi bien une liaison mécanique qu'une connexion électrique entre les différents dispositifs planaires. Un dispositif tridimensionnel fabriqué de cette manière présente l'avantage considérable d'être démontable, ce qui n'est guère concevable lorsqu'on utilise les techniques de l'art antérieur.

L'intégration tridimensionnelle pose des graves problèmes de dissipation thermique ; les éléments d'interconnexion de l'invention peuvent y apporter une solution originale, comme le montre les figures 4A et 4B.

La figure 4A représente une puce microélectronique 200 destinée à faire part d'un empilement tridimensionnel de circuits intégrés. Ses surfaces supérieure - référence 21 - et inférieure - non visible - portent des éléments d'interconnexion réalisés selon le procédé de l'invention, en utilisant des plages de métallisation en tant que substrats. On peut distinguer deux groupes d'éléments d'interconnexion 22, 22' de forme sensiblement carrée ; ces éléments d'interconnexion assurent le passage de signaux électriques et contribuent à former une liaison mécanique entre la puce 200 et les autres puces (références 210 et 220 sur la figure 4B) qui seront disposées au-dessus et au-dessous d'elle. Les éléments d'interconnexion 23 et 24 se présentent sous la forme de bandes parallèles, non nécessairement rectilignes, qui traversent la puce 200 d'un côté à l'autre. Ces éléments d'interconnexion sont électriquement isolés de la puce (leur substrat est constitué d'une métallisation réalisée au-dessus d'une couche isolante, par exemple en SiO₂). De même, la région 25 de la surface de la puce comprise entre les bandes 23, 24 est passivée. On peut voir sur la figure que la surface inférieure de la puce présente à son tour des éléments d'interconnexion en forme de bandes parallèles 26, 27.

Lorsque plusieurs puces du même type, présentant des éléments d'interconnexion correspondants, sont empilées et pressées les unes contre les autres, on obtient une structure tridimensionnelle du type représenté sur la figure 4B.

La figure 4B montre que les éléments conducteurs en forme de bande 23, 24 et la région 25 qu'elles délimitent forment, avec les parties correspondantes de la puce adjacente 210, un canal ou tube 30. Les éléments d'interconnexion 23, 24 forment des parois étanches : par conséquent, il est possible de faire circuler dans ce canal (et dans tous les canaux formés aux interfaces entre les différentes puces) un fluide caloporteur pour évacuer la chaleur dissipée par les circuits électroniques de la structure.

## Revendications

1. Procédé de fabrication d'un élément d'interconnexion mécanique conducteur d'électricité (12), ledit procédé comportant les étapes consistant à :
i. disposer, dans une cellule électrolytique (CE), une solution électrolytique (1) d'un composé précurseur d'un matériau métallique ;
ii. immerger dans ladite solution un substrat conducteur (2) dont au moins une face est revêtue d'une membrane poreuse (3), présentant un réseau sensiblement régulier de pores rectilignes et traversants ;
iii. disposer une électrode (5) en regard de ladite ou de chaque membrane poreuse, mais espacée de cette dernière ;
iv. relier ledit substrat à une borne négative d'un générateur d'électricité (6), de manière à qu'il constitue une cathode, et ladite électrode à une borne positive dudit générateur, de manière à qu'elle constitue une anode, pour effectuer un dépôt électrolytique dudit matériau métallique sur la surface du substrat à travers les pores de ladite membrane ;
v. dissoudre ladite membrane poreuse, de manière à libérer une structure (10) comportant une pluralité de fils (2a) de diamètre sub-micrométrique constitués dudit matériau métallique et faisant saillie de la surface dudit substrat (2) ;
**caractérisé en ce que** ledit procédé comporte également une étape additionnelle vi. de dissolution contrôlée partielle desdits fils (2a) pour en réduire le diamètre de manière à augmenter la force d'adhésion qui s'exerce entre deux desdites structures, par interpénétration et enchevêtrement desdits fils, lorsqu'elles sont pressées l'une contre l'autre.

2. Procédé selon la revendication 1, dans lequel ladite membrane poreuse (3) est réalisée en matériau céramique, et de préférence en alumine.

3. Procédé selon l'une des revendications précédentes, dans lequel ladite membrane poreuse (3) présente une densité de pores comprise entre 10⁷ cm⁻² et 10¹⁰ cm⁻², et dé préférence de l'ordre de 10⁹ cm⁻².

4. Procédé selon l'une des revendications précédentes dans lequel, après ladite étape vi de dissolution contrôlée partielle, lesdits fils présentent un diamètre compris entre 5 et 300 nm, et de préférence entre 10 et 200 nm.

5. Procédé selon l'une des revendications précédentes dans lequel, après ladite étape vi de dissolution contrôlée partielle, lesdits fils (2a) présentent une longueur comprise entre 200 nm et 200 µm, et de préférence entre 500 nm et 100 µm.

6. Procédé selon l'une des revendications précédentes dans lequel, après ladite étape vi de dissolution contrôlée partielle, ledit élément d'interconnexion (12) présente une porosité comprise entre 0,5 et 0,9.

7. Procédé selon l'une des revendications précédentes dans lequel ledit matériau métallique est choisi parmi : Cu, Sn, Co, Fe, Pb, Ni, Cr, Au, Pd, Pt, Ag, Bi, Sb, Al, Si ou Li, ou un alliage de ces métaux.

8. Procédé selon l'une des revendications précédentes dans lequel ladite étape de dissolution partielle contrôlée est réalisée par un procédé choisi parmi :
- un procédé de dissolution électrolytique ; et
- un procédé comportant l'immersion de ladite structure dans une solution permettant l'oxydation dudit matériau métallique, ainsi que la solubilisation des produits d'oxydation de ce dernier.

9. Procédé pour la réalisation d'une interconnexion mécanique, comportant les étapes consistant à :
- fabriquer deux éléments d'interconnexion (12, 12') par un procédé selon l'une des revendications précédentes ; et
- disposer face à face lesdits éléments d'interconnexion et les presser l'un contre l'autre de manière à réaliser une interpénétration et un enchevêtrement des fils nanométriques faisant saille des surfaces desdits éléments.

10. Procédé de fabrication d'un dispositif microélectronique tridimensionnel constitué par un empilement d'une pluralité de puces microélectroniques (200, 210, 220) reliées entre elles mécaniquement et électriquement, **caractérisé en ce qu'**au moins l'interconnexion mécanique entre lesdites puces est réalisée conformément à l'une des revendications 8 et 9.

11. Procédé selon la revendication 10, dans lequel au moins certains (23, 24, 25, 26) des éléments d'interconnexion mécanique reliant entre elles lesdites puces microélectroniques forment des canaux (30) étanches pour la circulation d'un fluide caloporteur.

12. Dispositif électronique tridimensionnel comportant un empilement de puces microélectroniques (200, 210, 220) reliées entre elles mécaniquement et électriquement, dans lequel des puces adjacentes dudit empilement présentent, sur leurs surfaces opposées, des éléments d'interconnexion (22, 22', 23, 24, 25, 26) se faisant face, comportant des plages de métallisation et une pluralité de fils de diamètre sub-micromètrique faisant saillie de ces dernières, dans lequel les puces sont reliées entre elles par interpénétration et enchevêtrement des fils desdits éléments d'interconnexion **caractérisé en ce que** au moins certains desdits éléments d'interconnexion (23, 24, 25, 26) se présentent sous la forme de bandes parallèles, non nécessairement rectilignes, qui traversent la puce d'un côté à un autre, de manière à constituer des parois étanches délimitant au moins un tube (30) pour la circulation d'un fluide caloporteur.

13. Dispositif électronique tridimensionnel selon la revendication 12, dans lequel la densité desdits fils de diamètre sub-micromètrique est comprise entre 10⁷ cm⁻² et 10¹⁰ cm⁻², et dé préférence de l'ordre de 10⁹ cm⁻².

14. Dispositif électronique tridimensionnel selon la revendication 12 ou 13, dans lequel lesdits fils présentent un diamètre compris entre 5 et 300 nm, et de préférence entre 10 et 200 nm.

15. Dispositif électronique tridimensionnel selon l'une des revendications 12 à 14, dans lequel lesdits fils présentent une longueur comprise entre 200 nm et 200 µm, et de préférence entre 500 nm et 100 µm.

16. Dispositif électronique tridimensionnel selon l'une des revendications 12 à 15, dans lequel ledit élément d'interconnexion (12) présente une porosité comprise entre 0,5 et 0,9.

17. Dispositif électronique tridimensionnel selon l'une des revendications 12 à 16 dans lequel lesdits fils de diamètre sub-micrométriques sont réalisés en un matériau métallique choisi parmi : Cu, Sn, Co, Fe, Pb, Ni, Cr, Au, Pd, Pt, Ag, Bi, Sb, Al, Si ou Li, ou un alliage de ces métaux.

## Patentansprüche

1. Verfahren zur Herstellung eines elektrisch leitenden mechanischen Verbindungselements (12), wobei das Verfahren die Schritte umfasst, die aus Folgendem bestehen:
i. Anordnen einer Elektrolytlösung (1) einer Verbindung einer Vorstufe eines metallischen Werkstoffs in einer Elektrolytzelle (CE);
ii. Eintauchen eines leitfähigen Substrats (2), von dem mindestens eine Seite von einer porösen Membran (3) bedeckt ist, die ein im Wesentlichen regelmäßiges Netz von geradlinigen und durchbohrenden Poren aufweist, in der Lösung;
iii. Anordnen einer Elektrode (5) der oder jeder porösen Membran gegenüberstehend aber von davon beabstandet;
iv. Verbinden des Substrats mit einem negativen Anschluss eines Stromgenerators (6), derart, dass es eine Kathode bildet, und der Elektrode mit einem positiven Anschluss des Generators, derart, dass sie eine Anode bildet, um eine elektrolytische Abscheidung des metallischen Werkstoffs auf der Fläche des Substrats durch die Poren der Membran durchzuführen;
v. Auflösen der porösen Membran, derart, dass eine Struktur (10) freigelegt wird, die mehrere Drähte (2a) mit submikrometrischem Durchmesser umfasst, die aus dem metallischen Werkstoff gebildet sind und von der Fläche des Substrats (2) hervorstehen;
**dadurch gekennzeichnet, dass** das Verfahren auch einen zusätzlichen Schritt vi der kontrollierten partiellen Auflösung der Drähte (2a) umfasst, um ihren Durchmesser zu verringern, derart, dass die Adhäsionskraft, die zwischen zwei der Strukturen ausgeübt wird, durch Verflechtung und Verschlingung der Drähte erhöht wird, wenn sie gegeneinander gedrückt werden.

2. Verfahren nach Anspruch 1, wobei die poröse Membran (3) aus keramischem Werkstoff und vorzugsweise aus Aluminiumoxid hergestellt wird.

3. Verfahren nach einem der vorhergehenden Ansprüche, wobei die poröse Membran (3) eine Porendichte aufweist, die zwischen 10⁷ cm⁻² und 10¹⁰ cm⁻² enthalten ist und vorzugsweise in der Größenordnung von 10⁹ cm⁻² liegt.

4. Verfahren nach einem der vorhergehenden Ansprüche, wobei die Drähte nach dem Schritt vi der kontrollierten partiellen Auflösung einen Durchmesser aufweisen, der zwischen 5 und 300 nm und vorzugsweise zwischen 10 und 200 nm enthalten ist.

5. Verfahren nach einem der vorhergehenden Ansprüche, wobei nach dem Schritt vi der kontrollierten partiellen Auflösung die Drähte (2a) eine Länge aufweisen, die zwischen 200 nm und 200 µm und vorzugsweise zwischen 500 nm und 100 µm enthalten ist.

6. Verfahren nach einem der vorhergehenden Ansprüche, wobei nach dem Schritt vi der kontrollierten partiellen Auflösung das Verbindungselement (12) eine Porosität aufweist, die zwischen 0,5 und 0,9 enthalten ist.

7. Verfahren nach einem der vorhergehenden Ansprüche, wobei der metallische Werkstoff unter: Cu, Sn, Co, Fe, Pb, Ni, Cr, Au, Pd, Pt, Ag, Bi, Sb, Al, Si oder Li oder einer Legierung aus diesen Metallen ausgewählt wird.

8. Verfahren nach einem der vorhergehenden Ansprüche, wobei der Schritt der kontrollierten partiellen Auflösung durch ein Verfahren ausgeführt wird, das unter Folgendem ausgewählt wird:
- einem elektrolytischen Auflösungsverfahren; und
- einem Verfahren, das das Eintauchen der Struktur in eine Lösung umfasst, die die Oxidation des metallischen Werkstoffs sowie die Solubilisierung der Oxdidationsprodukte dieses letzteren ermöglicht.

9. Verfahren zur Ausführung einer mechanischen Verbindung, das die Schritte umfasst, die aus Folgendem bestehen:
- Herstellen von zwei Verbindungselementen (12, 12') durch ein Verfahren nach einem der vorhergehenden Ansprüche; und
- gegenüberliegendes Anordnen und Gegeneinanderdrücken der Verbindungselemente, derart, dass eine Verflechtung und eine Verschlingung der nanometrischen Drähte ausgeführt wird, die von den Flächen der Elemente hervorstehen.

10. Verfahren zur Herstellung einer dreidimensionalen mikroelektronischen Vorrichtung, die durch eine Stapelung mehrerer Mikrochips (200, 210, 220) gebildet wird, die mechanisch und elektrisch untereinander verbunden werden, **dadurch gekennzeichnet, dass** mindestens eine mechanische Verbindung zwischen den Chips nach einem der Ansprüche 8 und 9 ausgeführt wird.

11. Verfahren nach Anspruch 10, wobei zumindest bestimmte (23, 24, 25, 26) der mechanischen Verbindungselemente, die die Mikrochips untereinander verbinden, dichte Kanäle (30) für den Umlauf eines Wärmeübertragungsmittels bilden.

12. Dreidimensionale elektronische Vorrichtung, die eine Stapelung von Mikrochips (200, 210, 220) umfasst, die mechanisch und elektrisch untereinander verbunden sind, wobei benachbarte Chips des Stapels auf ihren gegenüberliegenden Flächen Verbindungselemente (22, 22', 23, 24, 25, 26) aufweisen, die einander gegenüberstehen, die Metallisierungsbereiche und mehrere Drähte mit submikrometrischem Durchmesser umfassen, die von diesen letzteren hervorstehen, wobei die Chips untereinander durch Verflechtung und Verschlingung der Drähte der Verbindungselemente ausgeführt sind, **dadurch gekennzeichnet, dass** zumindest bestimmte der Verbindungselemente (23, 24, 25, 26) die Form paralleler Streifen aufweisen, die nicht notwendigerweise geradlinig sind, die den Chip von einer Seite zur anderen durchqueren, derart, dass dichte Wände gebildet werden, die mindestens ein Rohr (30) für den Umlauf eines Wärmeübertragungsmittels abgrenzen.

13. Dreidimensionale elektronische Vorrichtung nach Anspruch 12, wobei die Dichte der Drähte mit submikrometischem Durchmesser zwischen 10⁷ cm⁻² und 10¹⁰ cm⁻² enthalten ist und vorzugsweise in der Größenordnung von 10⁹ cm⁻² liegt.

14. Dreidimensionale elektronische Vorrichtung nach Anspruch 12 oder 13, wobei die Drähte einen Durchmesser aufweisen, der zwischen 5 und 300 nm und vorzugsweise zwischen 10 und 200 nm enthalten ist.

15. Dreidimensionale elektronische Vorrichtung nach einem der Ansprüche 12 bis 14, wobei die Drähte eine Länge aufweisen, die zwischen 200 nm und 200 µm und vorzugsweise zwischen 500 nm und 100 µm enthalten ist.

16. Dreidimensionale elektronische Vorrichtung nach einem der Ansprüche 12 bis 15, wobei das Verbindungselement (12) eine Porosität aufweist, die zwischen 0,5 und 0,9 enthalten ist.

17. Dreidimensionale elektronische Vorrichtung nach einem der Ansprüche 12 bis 16, wobei die Drähte mit submikrometrischem Durchmesser aus einem metallischen Werkstoff ausgeführt sind, der unter: Cu, Sn, Co, Fe, Pb, Ni, Cr, Au, Pd, Pt, Ag, Bi, Sb, Al, Si oder Li oder einer Legierung aus diesen Metallen ausgewählt ist.

## Claims

1. A method of fabricating an electrically conductive mechanical interconnection element (12), said method comprising the steps consisting in:
i) placing in an electrolytic cell (CE), an electrolytic solution (1) of a compound that is a precursor of a metallic material;
ii) immersing in said solution a conductive substrate (2) having at least one face coated in a porous membrane (3) presenting a substantially regular array of rectilinear through pores;
iii) providing an electrode (5) facing said or each porous membrane, but spaced apart therefrom;
iv) connecting said substrate to a negative terminal of an electricity generator (6) so as to constitute a cathode, and connecting said electrode to a positive terminal of said generator so as to constitute an anode, in order to perform electrolytic deposition of said metallic material on the surface of the substrate through the pores of said membrane;
v) dissolving said porous membrane so as to release a structure (10) comprising a plurality of wires (2a) of sub-micrometric diameter made of said metallic material and projecting from the surface of said substrate (2);
said method being **characterized in that** it further comprises an additional step of:
vi) controlled partial dissolution of said wires (2a) to reduce the diameter thereof so as to increase the force of adhesion that acts between two said structures as a result of said wires interpenetrating and tangling together when the structures are pressed one against the other.

2. A method according to claim 1, wherein said porous membrane (3) is made of a ceramic material, preferably in alumina.

3. A method according to any preceding claim, wherein said porous membrane (3) presents pore density lying in the range 10⁷ cm⁻² to 10¹⁰ cm⁻², and is preferably about 10⁹ cm⁻².

4. A method according to any preceding claim, wherein, after said step vi) of controlled partial dissolution, said wires present a diameter lying in the range 5 nm to 300 nm, and preferably in the range 10 nm to 200 nm.

5. A method according to any preceding claim, wherein, after said step vi) of controlled partial dissolution, said wires (2a) present a length lying in the range 200 nm to 200 µm, and preferably in the range 500 nm to 100 µm.

6. A method according to any preceding claim, wherein, after said step vi) of controlled partial dissolution, said interconnection element (12) presents porosity lying in the range 0.5 to 0.9.

7. A method according to any preceding claim, wherein said metallic material is selected from: Cu, Sn, Co, Fe, Pb, Ni, Cr, Au, Pd, Pt, Ag, Bi, Sb, Al, Si, and Li, or an alloy of said metals.

8. A method according to any preceding claim, wherein said step of controlled partial dissolution is performed by a method selected from
- an electrolytic dissolution method; and
- immersing said structure in a solution enabling said metallic material to be oxidized and also enabling the oxidation products thereof to be dissolved.

9. A method of making a mechanical interconnection, the method comprising the steps consisting in:
· fabricating two interconnection elements (12, 12') by a method according to any preceding claim; and
· placing said interconnection elements face to face and pressing one against the other so as to cause the nanometric wires projecting from the surfaces of said elements to interpenetrate and tangle together.

10. A method of fabricating a three-dimensional microelectronic device constituted by a stack of a plurality of microelectronic chips (200, 210, 220) mechanically and electrically connected to one another, the method being **characterized in that** at least one mechanical interconnection between said chips is made in accordance with claim 9 or claim 10.

11. A method according to claim 10, wherein at least some of the mechanical interconnection elements (23, 24, 25, 26) connecting said microelectronic chips together form channels (30) that are leaktight for circulating a coolant fluid.

12. A three-dimensional electronic device comprising a stack of microelectronic chips (200, 210, 220) mechanically and electrically connected to one another, wherein adjacent chips in said stack present, on their opposite faces, facing interconnection elements (22, 22', 23, 24, 25, 26) comprising areas of metal plating and a plurality of wires of sub-micrometric diameter projecting therefrom, and wherein the chips are interconnected by the wires of said interconnection elements interpenetrating and tangling together, **characterized in that** at least some of said interconnection elements (23, 24, 25, 26) are in the form of parallel strips, not necessarily rectilinear, crossing the chip from one side to another so as to constitute leaktight walls defining at least one tube (30) for circulating a cooling fluid.

13. A three-dimensional electronic device according to claim 12, wherein the density of said wires of sub-micrometric diameter lies in the range 10⁷ cm⁻² to 10¹⁰ cm⁻², and is preferably about 10⁹ cm⁻².

14. A three-dimensional electronic device according to claim 12 or claim 13, wherein said wires present a diameter lying in the range 5 nm to 300 nm, and preferably in the range 10 nm to 200 nm.

15. A three-dimensional electronic device according to any one of claims 12 to 14, wherein said wires present a length lying in the range 200 nm to 200 µm, and preferably lying in the range 500 nm to 100 µm.

16. A three-dimensional electronic device according to any one of claims 12 to 15, wherein said interconnection element (12) presents porosity lying in the range 0.5 to 0.9.

17. A three-dimensional electronic device according to any one of claims 12 to 16, wherein said wires of sub-micrometric diameter are made of a metallic material selected from: Cu, Sn, Co, Fe, Pb, Ni, Cr, Au, Pd, Pt, Ag, Bi, Sb, Al, Si, and Li, or an alloy of said metals.
